(19) Europäisches Patentamt
European Patent Office
Office européen des brevets

(11) **EP 2 418 673 A2**

(12) **EUROPÄISCHE PATENTANMELDUNG**

(43) Veröffentlichungstag:
**15.02.2012 Patentblatt 2012/07**

(51) Int Cl.:
**H01J 37/145** (2006.01)    **H01J 37/30** (2006.01)

(21) Anmeldenummer: **11008617.0**

(22) Anmeldetag: **17.07.2003**

(84) Benannte Vertragsstaaten:
**CZ DE GB NL**

(30) Priorität: **19.07.2002 DE 10233002**

(62) Dokumentnummer(n) der früheren Anmeldung(en) nach Art. 76 EPÜ:
**03016238.2 / 1 385 193**

(71) Anmelder: **Carl Zeiss NTS GmbH**
**73447 Oberkochen (DE)**

(72) Erfinder:
• **Preikszas, Dirk**
**73447 Oberkochen (DE)**

• **Steigerwald, Michael**
**73463 westhausen (DE)**
• **Hoffrogge, Peter**
**73447 Oberkochen (DE)**
• **Gnauck, Peter**
**72764 Reutlingen (DE)**

(74) Vertreter: **Diehl & Partner GbR**
**Patentanwälte**
**Augustenstrasse 46**
**80333 München (DE)**

Bemerkungen:
Diese Anmeldung ist am 27-10-2011 als Teilanmeldung zu der unter INID-Code 62 erwähnten Anmeldung eingereicht worden.

(54) **Objektivlinse für ein Elektronenmikroskopiesystem und Elektronenmikroskopiesystem**

(57) Eine Objektivlinse für ein Elektronenmikroskopiesystem umfasst eine rotationssymmetrische Polschuhanordnung zur Erzeugung eines fokussierenden Magnetfeldes mit einem inneren Polschuh (111) und einem äußeren Polschuh (112) mit einem in z-Richtung orientierten Spalt, einen Spulenkörper (115) und eine rotationssymmetrische Elektrodenanordnung zur Erzeugung eines fokussierenden elektrostatischen Feldes mit Strahlrohr (113) und einer mit Abstand von dem unteren Ende des Strahlrohrs angeordneten Abschlusselektrode (114); wobei der äußere Polschuh außen im Wesentlichen durch eine Konusfläche mit einem Konuswinkel $\alpha$ zur z-Richtung begrenzt ist, wobei die Abschlusselektrode außen im Wesentlichen durch eine Konusfläche mit einem Konuswinkel $\alpha'$ zur z-Richtung begrenzt ist, wobei die Abschlusselektrode zum Reduzieren des Magnetfelds in der Objektebene im Wesentlichen spaltfrei magnetisch an den äußeren Polschuh gekoppelt ist.

Fig. 4

EP 2 418 673 A2

**Beschreibung**

Die Erfindung betrifft ein Elektronenmikroskopiesystem mit magnetischer und elektrostatischer Fokussierung und insbesondere eine Objektivlinse für ein solches System. Ferner betrifft die Erfindung ein Untersuchungssystem zum Abbilden und Manipulieren eines Objektes, welches ein solches Elektronenmikroskopiesystem umfasst.

In einer Vielzahl von Fachbereichen und Anwendungsgebieten zeichnet sich ein zunehmender Trend zur Miniaturisierung ab. Insbesondere in der Halbleitertechnologie besteht Nachfrage an immer kleineren, komplexeren und leistungsstärkeren Bauelementen. Es besteht somit beispielsweise im Rahmen von Qualitätssicherung und Prozessanalyse ein Bedarf, die Wafer und darauf entstehende bzw. fertige Bauelemente optisch inspizieren zu können. Da die Größe der einzelnen Strukturen der Bauelemente im Mikrometerbereich und darunter liegt, werden üblicherweise Elektronenmikroskope verwendet, um eine notwendige Vergrößerung und Auflösung zu erzielen. Besonders vorteilhaft sind dabei solche Elektronenmikroskopiesysteme, welche eine Abbildung der zu untersuchenden Struktur unter einer großen Zahl von Beobachtungswinkeln zulassen, was bei zunehmender Wafergröße spezielle Anforderungen an die elektronenmikroskopische Anordnung stellt. Im Rahmen einer Charakterisierung einer Struktur, insbesondere einer Halbleiterstruktur, besteht eine Technik darin, einen Graben in die zu charakterisierende Struktur zu "fräsen", um einen Querschnitt durch die Struktur untersuchen zu können und so mit relativ geringem Arbeitsaufwand eine Fülle von Informationen, z. B. bezüglich Schichtenfolgen in der Struktur, erhalten zu können. Ein solcher Graben wird beispielsweise mit Hilfe eines fokussierten Ionenstrahls (focused ion beam, FIB) in die Halbleiterstruktur geätzt. Diese Ätzmethode ist besonders für die Herstellung von Probenquerschnitten für die Transmissionselektronenmikroskopie oder bei einer Struktur mit einer komplexen Schichtenfolge und unterschiedlicher Ätzselektivität der einzelne Schichten von Bedeutung. Verfahren unter Verwendung eines FIB erlauben die Herstellung recht feiner und wohldefinierter Schnitte. Es ist bei dieser Methode vorteilhaft, den Ätzvorgang in situ mikroskopisch beobachten können.

Aus dem Stand der Technik sind bereits verschiedene Elektronenmikroskopiesysteme sowie eine Zahl von in solchen Systemen anwendbaren Objektivlinsen bekannt. Eine solche Objektivlinse, die sich als vorteilhaft erwiesen hat, sieht eine Kombination aus magnetischer und elektrostatischer Fokussierung bzw. Verzögerung vor.

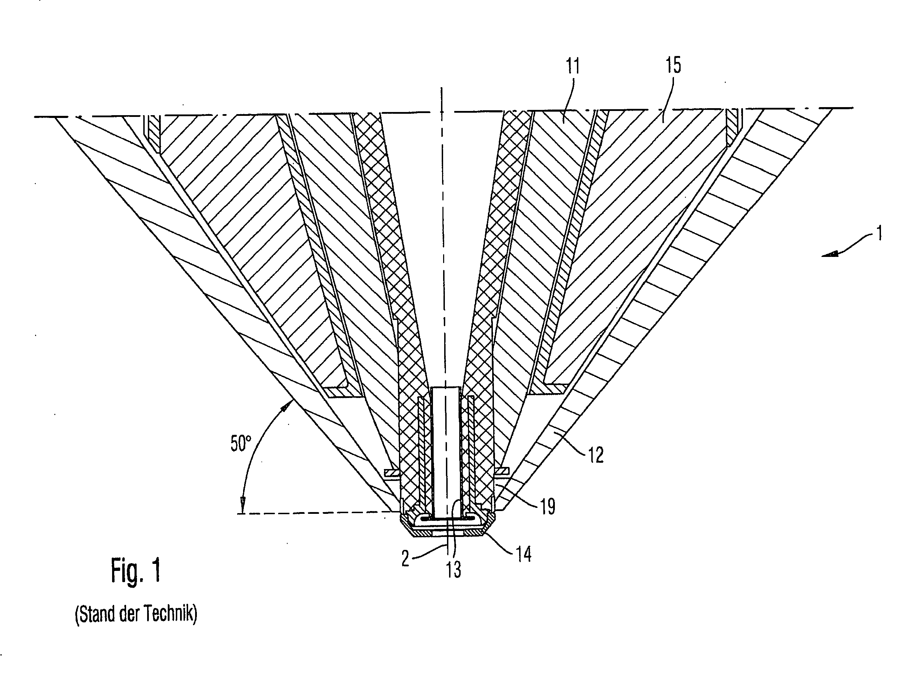

Ein Beispiel einer herkömmlichen Objektivlinse ist in Figur 1 schematisch dargestellt. Die Objektivlinse 1 umfasst eine rotationssymmetrisch um eine optische Achse 2 der Objektivlinse angeordnete magnetische Linse mit einer Polschuhanordnung mit einem inneren Polschuh 11 und einem äußeren Polschuh 12 sowie mit einem in einem Raum zwischen innerem und äußerem Polschuh 11, 12 angeordneten Spulenkörper 15. Ferner umfasst die Objektivlinse 1 eine elektrostatische Immersionslinse mit einem eine erste Elektrode bildenden Strahlrohr 13 und einer Abschlusselektrode 14. Das Strahlrohr 13 ist im Wesentlichen in einem unteren Teil eines durch den inneren Polschuh 11 gebildeten Innenraums angeordnet, während die Abschlusselektrode 14 sich räumlich im Wesentlichen in z-Richtung an den äußeren Polschuh anschließt. Werden die zwischen den Polschuhen angeordneten Spulenwindungen der magnetischen Linse von Strom durchflossen, so wird im inneren Polschuh 11 und im äußeren Polschuh 12 ein magnetischer Fluss induziert. Dabei führt das Polschuhmaterial einen großen Teil des Flusses. In einem Bereich eines axialen Polschuhspalts 19 tritt ein durch die Polschuhe 11, 12 geklammertes magnetisches Feld bis auf die optische Achse 2 aus. Magnetfeldstärke und Ausdehnung des Magnetfeldes auf der optischen Achse 2 sind für die Fokuslänge von Bedeutung. Dabei ist die Brennweite proportional zur Beschleunigungsspannung der Elektronen geteilt durch das Ortsintegral über das Quadrat der magnetischen Flussdichte im Bereich der Polschuhe entlang des z-Achse.

Am Strahlrohr 13 der elektrostatischen Linse wird eine positive Spannung angelegt, während die Abschlusselektrode 14 vorzugsweise auf Erdpotential geschaltet ist. Die elektrostatische Linse erzeugt ein Verzögerungsfeld, in dem die Elektronen des Elektronenstrahls vor Verlassen der Elektronenoptik abgebremst werden. Dies erlaubt, dass die Elektronen des Elektronenstrahls den größten Teil des Strahlengangs zwischen Elektronenquelle und elektrostatischer Linse mit hoher Energie bzw. Geschwindigkeit durchlaufen können und so sich auf die Fokussierung negativ auswirkende elektrostatische Abstoßungserscheinungen der gleich geladenen Elektronen minimieren lassen. Das elektrostatische Feld zwischen Strahlrohrende und Abschlusselektrode 14 weist ferner eine Inhomogenität derart auf, dass dieses Feld ebenfalls fokussierend auf die dieses durchlaufende Primärelektronen wirkt.

Weiterhin hat sich als günstig erwiesen, dass ein durch die Magnetlinse der Objektivlinse erzeugtes Magnetfeld auf der Oberfläche eines Objekts - beispielsweise im Vergleich mit sog. "single-pole"-Linsen - relativ gering ist. Wie in Figur 1 dargestellt, weist Objektivlinse 1 einen im Wesentlichen konischen äußeren Polschuh 12 mit einem Konuswinkel einer äußeren Seite des äußeren Polschuhs zur optischen Achse von 40° auf. Bedingt durch die Geometrie des äußeren Polschuhs 12 und den im Wesentlichen durch diese bestimmten Raumbedarf der elektronenmikroskopischen Linsenanordnung läßt sich ein zu untersuchendes Objekt bei einem kleinen Arbeitsabstand bis hin zu einem Winkel von 90° - 40° = 50° relativ zur optischen Achse des Elektronenmikroskopiesystems kippen.

Eine Elektronenmikroskopieanordnung, welche eine solche Objektivlinse umfasst, wurde ebenfalls vorteilhaft in einer Anordnung zum Abbilden und Manipulieren eines Objekts, die zusätzlich eine Vorrichtung zum Erzeugen und Steuern eines fokussierten Ionenstrahls (im Folgenden auch als Ionenstrahlbearbeitungssystem oder FIB-Säule bezeichnet) aufweist, eingesetzt. Insbesondere ermöglicht es eine solche Anordnung, Abbilden und Bearbeiten der Struktur simultan auszuführen. Aufgrund des Raumbedarfs der obig beschriebenen Objektivlinse der elektronenoptischen Anordnung sowie der FIB-Säule kann ein zu untersuchendes flächig ausgedehntes Objekt bei simultanem Abbilden und Bearbeiten maximal bis zu einem Winkel von 80° relativ zum lonenstrahl angeordnet werden. Somit lassen sich in einem eine solche herkömmliche Objektivlinse umfassenden System mit Hilfe des FIB keine Gräben mit vertikalen Wänden in einem Objekt bei simultaner Abbildung durch das Elektronenmikroskop erzeugen. Vielmehr wird nach einem Arbeitsschritt zur Bearbeitung des Objekts durch den FIB das Objekt gekippt und verdreht, und anschließend die durch den FIB erzeugte Struktur abgebildet.

Bei gleichzeitigem Betreiben von Elektronenmikroskopieanordnung und fokussiertem lonenstrahl ist allgemein ein Magnetfeld im Bereich des durch den lonenstrahl manipulierten Objekts zu minimieren, da die lonen durch das Magnetfeld abgelenkt werden, was zu einer Beeinträchtigung der Bearbeitungspräzision des fokussierten lonenstrahls führt. Ferner kann in einem solchen Magnetfeld eine Aufspaltung des lonenstrahls nach Isotopen auftreten, was eventuell dessen Verwendbarkeit ganz ausschließt.

Entsprechend besteht ein Bedarf an einer Objektivlinse für ein Elektronenmikroskopiesystem, welche einen verringerten Raumbedarf und ein minimiertes Magnetfeld außerhalb der Objektivlinse aufweist.

Es ist daher eine Aufgabe der Erfindung, eine verbesserte Objektivlinse für ein Elektronenmikroskopiesystem bereitzustellen. Es ist ferner eine Aufgabe der Erfindung, ein verbessertes Untersuchungssystem zum simultanen Abbilden und Manipulieren eines zu untersuchenden Objekts vorzuschlagen.

Unter einem ersten Aspekt wird eine Objektivlinse für ein Elektronenmikroskopiesystem mit magnetischer und elektrostatischer Fokussierung zum Abbilden eines in einer Objektebene anordenbaren Objekt bereitgestellt, welche umfasst:

● eine Polschuhanordnung zur Erzeugung eines fokussierenden Magnetfeldes, welche bezüglich einer sich in einer z-Richtung erstreckenden optischen Achse der Objektivlinse im Wesentlichen rotationssymmetrisch ist und einen inneren Polschuh und einen äußeren Polschuh aufweist,

wobei an einer in z-Richtung untersten Stelle des inneren Polschuhs, wo dieser von dem äußeren Polschuh einen in z-Richtung orientierten Spaltabstand aufweist, zwischen dem inneren und dem äußeren Polschuh ein Polschuhspalt ausgebildet ist,

● eine Elektrodenanordnung zur Erzeugung eines fokussierenden elektrostatischen Feldes, welche bezüglich der optischen Achse im Wesentlichen rotationssymmetrisch ist, und umfasst: ein Strahlrohr, welches den inneren Polschuh entlang der optischen Achse durchsetzt und ein unteres Ende aufweist, und weiterhin eine mit Abstand von dem unteren Ende des Strahlrohrs angeordnete Abschlusselektrode,

● wobei die Objektivlinse dadurch gekennzeichnet ist, dass in einem Bereich innerhalb von wenigstens 3 cm um den Polschuhspalt herum gilt:

- der innere Polschuh verjüngt sich wenigstens bereichsweise (in z-Richtung) nach unten und weist dort einen inneren Konuswinkel β und einen äußeren Konuswinkel χ zur z-Richtung auf,

- der äußere Polschuh erstreckt sich nach unten, insbesondere verjüngt er sich hierbei wenigstens bereichsweise, und weist unten einen inneren Konuswinkel Δ und einen äußeren Konuswinkel α zur z-Richtung auf, und dass weiterhin die Objektivlinse dazu ausgebildet ist, dass

- ein Arbeitsabstand $W_D$ zwischen der Abschlusselektrode und der Objektebene für Elektronen, die das Strahlrohr mit etwa 30 keV durchlaufen, kleiner als oder gleich 2 mm ist,

und dass weiterhin gilt:

$$- \quad 30° < \alpha < 35° \text{ und } 10° < \Delta\text{-}\chi < 14°.$$

In besonders bevorzugten Ausführungsformen umfasst die Objektivlinse weiterhin einen in einem Raum zwischen dem inneren und dem äußeren Polschuh angeordneten Spulenkörper.

Im Wesentlichen wurden Geometrie und Anordnung der Komponenten der herkömmlichen Objektivlinse verändert, um unter einem ersten Aspekt so den Winkel zwischen konischem äußeren Polschuh und z-Achse verringern zu können und damit den Raumbedarf der Objektivlinse und damit elektronenmikroskopischen Anordnung zu verringern. Dadurch kann ein im Wesentlichen flächig ausgedehntes Objekt bezüglich der optischen Achse der Elektronenmikroskopieanordnung stärker gekippt werden.

Die vorgeschlagene Änderung der Geometrie der herkömmlichen Objektivlinse, die zu einer die Aufgabe(n) lösenden Objektivlinse mit für das Elektronenmikroskopiesystem zufriedenstellenden optischen Parametern führt, ist dabei für den Fachmann nicht naheliegend, sondern aus einer Reihe von Gründen überraschend, wie nachfolgend dargestellt:

In der magnetischen Linse der Objektivlinse sollen der innere und der äußere Polschuh den gesamten magnetischen Fluss führen, so dass das magnetische Feld im Wesentlichen nur für die kurze Strecke des Polschuhspalts aus diesen austritt. Weiterhin ist eine magnetische Sättigung des die Polschuhe ausbildenden Materials zu vermeiden, da eine solche Sättigung zu unreproduzierbaren und nicht rotationssymmetrischen Magnetfeldern und zu einer Verdrängung des Magnetflusses aus den Polschuhen heraus führen würde. Eine Fokussierung energiereicher Elektronenstrahlen würde im Falle einer Polschuhmaterialsättigung aufgrund des abgeschwächten Magnetfeldes beeinträchtigt. Daher würde eine Verringerung des Raumbedarfs der Magnetlinse durch eine Verringerung der Dicke der Polschuhe und damit Materialabtrag unter Beibehaltung der zur magnetischen Anregung durch die zwischen den Polschuhen angeordneten Spule verwendeten Parameter eine vorzeitige magnetische Sättigung des Materials und damit unzureichendes Fokussierungsvermögen der Objektivlinse erwarten lassen. Versuchte man, die Magnetlinse durch Verringerung des Abstandes, d. h. der Winkeldifferenz von innerem und des äußerem Polschuh zu verkleinern, würde diese Verringerung zu magnetischem Kurzschluss und damit zu nachteiligen Störungen des Magnetfeldes, insbesondere Verschiebungen, Verformungen und Abschwächungen des Feldes entlang der optischen Achse, führen. Außerdem würde dadurch der für die Spule zur Verfügung stehende Raum verkleinert, infolgedessen müsste zum Erhalt der zu einer genügenden Erregung notwendigen Anzahl der Windungen der Spule ein kleinerer Drahtdurchmesser für den für die Spule verwendeten Draht gewählt werden. Der mit einem kleineren Drahtdurchmesser verbundene höhere Ohm'sche Widerstand würde jedoch die von dem Draht der Spule erzeugte Wärmemenge erhöhen, was zur Vermeidung räumlicher Drifterscheinungen eine aufwendigere Kühlung als die verwendete Wasserkühlung erforderlich machen würde. Daher scheinen Materialabtrag an den Polschuhen und/oder eine Verringerung des Abstandes des inneren und äußeren Polschuhs keine geeignete Maßnahmen zur Lösung der Aufgabe zu sein.

Zusammen mit einer Verringerung des Winkels $\alpha$ zwischen der Außenseite des äußeren Polschuhs und einer Verringerung der Dicken der Polschuhe wurde auch eine Anordnung der Polschuhe zueinander, insbesondere die Differenz des Winkels zwischen dem äußeren Winkel $\chi$ des inneren Polschuhs zur z-Achse und dem inneren Winkel $\Delta$ des äußeren Polschuhs zur z-Achse, und die Abmessung des Polschubspalts bzw. -abstands, in nicht durch den Stand der Technik nahegelegter Weise abgewandelt, um zu einer überraschend leistungsfähigen Objektivlinse zu gelangen:

Zumindest in einem Bereich innerhalb von etwa 3 cm um den Polschuhspalt liegt $\alpha$ erfindungsgemäß in einem Bereich von 30° bis 35°, die Differenz $\Delta$-$\chi$ in einem Bereich von 10° bis 14°, wobei mit dieser Anordnung bei Verwendung von Elektronen, die das Strahlrohr mit etwa 30 keV durchlaufen, ein Arbeitsabstand zwischen der Abschlusselektrode und der Objektebene kleiner als oder gleich 2 mm erreicht wird.

Der Arbeitsabstand ist hier als Abstand zwischen einem untersten Bereich bzw. einem unteren Ende der Abschlusselektrode und der Objektebene bzw. einem in diese angeordneten Objekt zu verstehen, wobei bei diesem Arbeitsabstand bei bestimmungsgemäßem Gebrauch eine auflösungsbeste Abbildung erzielt werden kann bzw. eine Auflösung erzielt werden kann, die nicht wesentlich verschieden ist von der spezifizierten Auflösung beim bestimmungsgemäßen Gebrauch.

Die Objektivlinse kann jedoch auch bei Verwendung größerer Arbeitsabstände vorteilhaft eingesetzt werden.

Besonders bevorzugt ist eine Anordnung, in der $\alpha$ = 34° und $\Delta$-$\chi$ = 13°.

An einer in z-Richtung untersten Stelle des inneren Polschuhs weist dieser von dem äußeren Polschuh einen in z-Richtung orientierten Spaltabstand auf, wo zwischen dem inneren und dem äußeren Polschuh ein Polschuhspalt ausgebildet ist. Im Bereich des Polschuhspalts tritt das Magnetfeld in Richtung der optischen Achse aus. Die Abmessungen des Polschuhspalts haben Einfluss auf die Stärke wie auch die räumliche Ausdehnung des magnetischen Feldes auf der optische Achse und damit auf die Fokuslänge der Objektivlinse. Bei der Optimierung der Polschuhgeometrie sind die Eigenschaften der sphärischen und chromatischen Aberration gegenüber der Fokussierleistung, die durch die Feldabflachung aufgrund von Materialsättigung oder zu großer Spaltbreite verringert wird, abzuwägen. Es wird ein Polschuhspaltabstand von mindestens 3 mm gewählt. Bei der Angabe dieses Abstandes ist zu beachten, dass es sich hier gewissermaßen um einen effektiven Polschuhspaltabstand handelt. Das bedeutet, dass es möglich ist, durch Hinzufügen weiteren Materials in Form beispielsweise eines dünnen Fortsatzes oder dünner Filme oder Folien den Polschuhspalt bzw. Polschuhabstand zwar unter einem geometrischen, nicht jedoch unter einem funktionellen Aspekt zu verkleinern. Durch dieses hinzugefügte Material werden nämlich infolge magnetischer Sättigung im hinzugefügten Material das von der Magnetlinse erzeugte Magnetfeld und damit die von dem inneren und äußeren Polschuh ausgehenden magnetischen Feldlinien nicht wesentlich beeinflusst, oder das Material wird an einer Stelle hinzugefügt, an der sich ohnehin kaum noch Fluss im Polschuh befindet.

In einer vorteilhaften Ausgestaltung der Erfindung erweitern sich eine innere und eine äußere Seite des inneren Polschuhs von einem in z-Richtung untersten Punkt des inneren Polschuhs in einer konischen Form nach oben. In einer alternativen, bevorzugten Ausführungsform ist der innere Polschuh derart ausgebildet, dass er sich von seinem unteren Ende in Form eines Zylindermantels etwa 1 mm bis 3 mm in z-Richtung nach oben erstreckt, bevor er sich dann zumindest auf einer äußeren Seite konisch erweitert. Bevorzugt verjüngt sich der äußere Polschuh nach unten.

Vorzugsweise weist der innere Polschuh zumindest an seinem unteren Ende einen Innendurchmesser von 6 mm bis 8 mm auf, wobei ein Innendurchmesser von 7,5 mm besonders bevorzugt ist.

Allgemein liegen die Konuswinkel unter Beachtung der zuvor aufgeführten Winkeldifferenzen bevorzugt in folgenden Bereichen:

● innerer Konuswinkel $\beta$ des inneren Polschuhs zur z-Achse: $0° < \beta < 15°$

● äußerer Konuswinkel $\chi$ des inneren Polschuhs zur z-Achse: $12° < \chi < \Delta\text{-}15°$

● innerer Konuswinkel $\Delta$ des äußeren Polschuhs zur z-Achse: $\alpha - 5° < \Delta < \alpha+1°$

Die Abmessung des radial innersten, axial um die Achse angeordneten untersten Bereichs des äußeren Polschuhs liegt bevorzugt in einem Bereich von 0,5 mm bis 3 mm, die Abmessung des radial innersten, axial um die Achse angeordneten untersten Bereichs des inneren Polschuhs beträgt bevorzugt 10 mm und mehr.

Damit wurde, entgegen den Erwartungen des Fachmanns, sowohl Material von den Polschuhen entfernt sowie eine Winkeldifferenz zwischen den Polschuhen verringert, wobei trotz größerem Spaltabstand ein Arbeitsabstand von 2 mm und kleiner erreicht wird.

In besonders bevorzugten Ausführungsformen ist ein in z-Richtung unteres Ende der Abschlusselektrode von einem in z-Richtung untersten Bereich des äußeren Polschuhs in z-Richtung mit Abstand angeordnet.

Besonders bevorzugt ist das Strahlrohr derart angeordnet, dass es eine durch einen in z-Richtung untersten Bereich des äußeren Polschuhs gebildete Öffnung des äußeren Polschuhs zumindest durchsetzt. In besonders bevorzugten Ausführungsformen durchsetzt das Strahlrohr die Öffnung des äußeren Polschuhs und ist das untere Ende des Stahlrohrs derart angeordnet, dass es in z-Richtung von der Öffnung des äußeren Polschuhs mit Abstand angeordnet ist, d. h. parallel zur optischen Achse verlaufend aus der Polschuhanordnung, insbesondere der Öffnung des äußeren Polschuhs heraustritt. Besonders bevorzugt ist also das untere Ende des Strahlrohrs in z-Richtung zwischen der Öffnung des äußeren Polschuhs und dem unteren Ende der Abschlusselektrode angeordnet.

Unter einem weiteren Aspekt der Erfindung zeichnet sich eine Objektivlinse, alternativ oder ergänzend zu der obig beschriebenen besonderen geometrischen Ausgestaltung der durch die Polschuhanordnung ausgebildeten Magnetlinse (einschließlich der bevorzugten Ausführungsformen), durch eine magnetische Kopplung des äußeren Polschuhs und der Abschlusselektrode aus. Diese magnetische Kopplung wird dadurch erreicht, dass der äußere Polschuh, welcher nach außen im Wesentlichen durch eine Konusfläche mit einem Konuswinkel $(\alpha)$ zur z-Richtung begrenzt ist, und die Abschlusselektrode, welche nach außen im Wesentlichen durch eine Konusfläche mit einem Konuswinkel $(\alpha')$ zur z-Richtung begrenzt ist, zum Reduzieren des Magnetfelds auf dem in der Objektebene anordenbaren Objekt im Wesentlichen spaltfrei magnetisch miteinander gekoppelt sind. Diese magnetische Kopplung bewirkt eine bessere Abschirmung des Magnetfeldes zu Bereichen außerhalb der Objektivlinse hin, was besonders vorteilhaft ist in Fällen, wo das Magnetfeld mit dem Objekt bzw. einer Probe störend interferiert oder auch bei der gleichzeitigen Bearbeitung des untersuchten Objekts mit Hilfe eines fokussierten Ionenstrahls, da das Magnetfeld die Ionen ablenken und damit den Bearbeitungsvorgang stören würde.

Besonders bevorzugt ist die Objektivlinse auch unter diesem Aspekt dazu ausgebildet, dass ein Arbeitsabstand kleiner als 2 mm ist für Elektronen, die das Strahlrohr mit etwa 30 keV durchlaufen.

In einer besonders bevorzugten Ausführungsform wird die magnetische Kopplung zwischen Abschlusselektrode und äußerem Polschuh dadurch erreicht, dass ein Spalt zwischen der Abschlusselektrode und dem äußeren Polschuh kleiner als 0,6 mm und noch mehr bevorzugt kleiner als 0,2 mm ist. Ein solcher Spalt zwischen Abschlusselektrode und äußerem Polschuh wird vorteilhaft dadurch ausgebildet, dass sich ein Bereich der Abschlusselektrode und ein Bereich des äußeren Polschuhs flächig gegenüberliegen.

Besonders bevorzugt liegen sich ein in z-Richtung oberster Bereich der Abschlusselektrode und der in z-Richtung unterste Bereich des äußeren Polschuhs flächig gegenüber, wobei bevorzugt die sich gegenüberliegenden Flächen parallel zur z-Richtung angeordnet sind, und weiter bevorzugt zumindest der dem äußeren Polschuh flächig gegenüberliegende Bereich der Abschlusselektrode innerhalb der durch den in z-Richtung untersten Bereich des äußeren Polschuhs gebildeten Öffnung angeordnet ist.

Besonders bevorzugt wird die Abschlusselektrode durch eine sich von einem unteren Bereich des äußeren Polschuhs aus entlang der Innenseite des inneren Polschuhs erstreckenden Kunststoffisolierung sowie elektrisch isolierte Klammern gehalten. Dies ermöglicht es insbesondere, die Abschlusselektrode, welche durch einen Spalt elektrisch isoliert von dem äußeren Polschuh ist, auf ein anderes Potential als Erdpotential schalten zu können, was für verschiedene Anwendungen vorteilhaft ist. Weiterhin erlaubt dies, die Abschlusselektrode unabhängig vom äußeren Polschuh austauschen zu können.

Weiter bevorzugt ist eine Anordnung von äußerem Polschuh und Abschlusselektrode, in der die sich zumindest teilweise im Wesentlichen konisch erstreckenden Außenseiten des äußeren Polschuhs und der Abschlusselektrode miteinander fluchten.

Die Abschlusselektrode ist vorteilhaft derart gestaltet, dass sie sich bis zu einer zentralen Öffnung am unteren Ende der Abschlusselektrode hin im Wesentlichen konisch verjüngt und so das elektrostatische Feld vergleichsweise nahe an einem Objekt bzw. einer Probe bereitgestellt wird. Da die Abschlusselektrode vorzugsweise auf Erdpotential geschaltet ist, ist in einem Bereich der Probe das elektrostatische Feld jedoch vernachlässigbar klein. Die Nähe des Feldes zur Probe ist insbesondere bei größeren Arbeitsabständen $W_D$, d. h. Abständen zwischen Abschlusselektrode und Probenoberfläche, von Vorteil. Der Innendurchmesser der zentralen Öffnung der Abschlusselektrode entspricht im Wesentlichen einem Innendurchmesser des Strahlrohrs, es sind aber auch Ausführungsformen vorgesehen, in denen die zentrale Öffnung am unteren Ende der Abschlusselektrode einen anderen Innendurchmesser aufweist als der Innendurchmesser des Strahlrohrs.

Unter einem dritten Aspekt der Erfindung ist die elektrostatische Linse der Objektivlinse, alternativ oder ergänzend zu den obig beschriebenen besonderen geometrischen Parametern der Magnetlinse und/oder magnetischen Kopplung von äußerem Polschuh und Abschlusselektrode einschließlich der in Zusammenhang mit diesen beschriebenen bevorzugten Ausführungsformen, derart ausgestaltet, dass ein Abstand $A_1$ zwischen dem unteren Ende des inneren Polschuhs und dem unteren Ende bzw. der in z-Richtung untersten Stelle des Strahlrohrs größer als 9 mm und weiter bevorzugt größer als 10 mm ist. Diese Ausgestaltung ist besonders bevorzugt zum Reduzieren des Magnetfeldes in der Objektebene vorgesehen. Besonders bevorzugt und besonders vorteilhaft ist bei dieser Ausgestaltung das untere Ende des Strahlrohrs in z-Richtung zwischen unterstem Bereich des äußeren Polschuhs und dem unteren Ende der Abschlusselektrode angeordnet. In einer besonders bevorzugten Ausführungsform ist ein Abstand $A_2$ zwischen dem unteren Ende des Strahlrohrs und dem unteren Ende der Abschlusselektrode größer als 3 mm, besonders bevorzugt ist ein Abstand von etwa 6 mm.

Dieser Anordnung liegt die Idee zugrunde, eine Überlappung des durch die Magnetlinse erzeugten Magnetfeldes und des durch die Abschlusselektrode und Strahlrohr umfassende elektrostatische Linse erzeugten elektrostatischen Feldes gegenüber der aus dem Stand der Technik bekannten Anordnung zu verkleinern. Insbesondere überlappen das elektrostatische und das magnetische Feld bei einer solchen Linsengeometrie bevorzugt um weniger als 5 % (bezogen auf die Feldintegrale). Damit weist das durch die magnetische Linse erzeugte Magnetfeld einen größeren Abstand zu einem abzubildenden Objekt auf, wodurch ein Magnetfeld in der Objektebene bzw. auf dem Objekt minimiert wird. Gründe, warum diese Feldminimierung auf dem Objekt vorteilhaft ist, wurden bereits zuvor angesprochen. Ein weiterer Vorteil dieser Anordnung liegt darin, dass das elektrostatische Feld nahe zur Probe angeordnet ist, was besonders bei größeren Arbeitsabständen vorteilhaft ist.

Besonders bevorzugt weist das untere Ende des Strahlrohrs einen Endflansch auf, welcher sich radial über einen Außendurchmesser des Strahlrohrs hinaus erstreckt. Dabei weist der das Strahlrohr umschließende Endflansch einen Abstand zu der Abschlusselektrode auf, welcher groß genug ist, um ein Auftreten elektrischer Überschläge oder Kurzschlüsse zu verhindern. Dieser Endflansch ist vorzugsweise derart ausgebildet, dass er im Axialquerschnitt von einem in Richtung der Objektebene weisenden Frontabschnitt zu einem Mantelabschnitt in verrundeter Form übergeht, wobei diese Verrundung einen Krümmungsradius von mindestens einem Millimeter aufweist. Dieser besonderen Ausgestaltung des Strahlrohrs liegt die Idee zugrunde, im Bereich im Wesentlichen zwischen innerem Polschuh und Strahlrohr angeordnete, aus Kunststoff gefertigte Komponenten der Objektivlinse vor einer Aufladung durch eine beim Betreiben der Elektronenmikroskopieanordnung unausweichlich auftretenden Elektronenwolke zu schützen, indem gewissermaßen der direkte Zugang zu diesem Bereich durch die Abschirmung durch den Endflansch erschwert wird und der Primärelektronenstahl ähnlich wie durch einen Faraday'schen Käfig abgeschirmt wird. Der Endflansch kann auch derart ausgestaltet sein, dass ein Übergang von der den Innendurchmesser begrenzenden Innenwand des Strahlrohrs zur Frontfläche verrundet ausgebildet ist.

Bei allen obig angeführten Ausgestaltungen wird für die Polschuhe vorzugsweise ein Material gewählt, das eine hohe Sättigungsmagnetisierung aufweist. Besonders bevorzugt wird für die Polschuhe eine Eisen-Nickel-Legierung mit einem Nickel-Gehalt von 45 % bis 50 % verwendet. Besonders bevorzugt ist eine NiFe-Legierung mit dem Handelsnamen "Permenorm 5000 H3", kommerziell erhältlich von der Vacuumschmelze Hanau, Deutschland. Vorteilhaft können auch eine Cobalt-Eisen-Vanadium-(49%Co-49%Fe-2%V)-Legierung, Cobalt-Eisen-Legierungen (z. B. 30 % Co, 70 % Fe) oder Weicheisen verwendet werden.

Das für den Spulenkörper verwendete Material umfasst vorzugsweise Kupferdraht. Der Spulenkörper ist thermisch von den Polschuhen isoliert, wobei bei Stromdurchfluss in dem Spulenkörper generierte Wärme von einem thermisch mit dem Spulenkörper gekoppelten, im Innenraum zwischen dem innern und dem äußeren Polschuh angeordneten Wasserkühlungsrohr aufgenommen und durch den Kühlkreislauf abtransportiert wird.

Für die Abschlusselektrode wird bevorzugt ein sogenanntes $\mu$Metall (Mumetall®), d.h. eine Nickel-Eisen-Legierung mit einem Nickel-Anteil von 72 - 89 %, gewählt, besonders bevorzugt Hyperm 766.

Bevorzugt sind in der Objektivlinse weiterhin mehrere Ablenkspulen zum Ablenken des Elektronenstrahls vorgesehen, so dass der Elektronenstrahl über einen definierten Bereich einer Objektoberfläche rastern kann. Neben der voranstehend beschriebenen Objektivlinse umfasst ein Elektronenmikroskopiesystem weitere Komponenten: eine Probenkammer, in der ein zu untersuchendes Objekt angeordnet ist, eine Elektronenstrahlquelle zum Erzeugen und Beschleunigen eines Elektronenstrahls, Elektronenoptik mit einer oder mehreren elektrostatischen und/oder magnetischen Linse(n), zumindest ein Vakuumsystem zum Evakuieren zumindest der vom Elektronenstrahl durchsetzten Räume des Elektronenmikroskops und der Probenkammer, eine Objekthalterung in der Probenkammer zum Anordnen und Ausrichten eines Objekts vor dem Elektronenmikroskop und zumindest einen Detektor zum Detektieren von Elektronen, insbesondere Sekundärelektronen. In einer bevorzugten Elektronenmikroskopieanordnung ist zumindest ein Detektor in einem Innenraum des Elektronenmikroskops, welcher in z-Richtung oberhalb der Objektivlinse angeordnet ist, vorgesehen.

Unter einem zusätzlichen Aspekt stellt die Erfindung ein Untersuchungssystem zur Beobachtung und zur Manipulation eines zu untersuchenden Objekts bereit, welches folgende Komponenten umfasst:

- ein Elektronenmikroskopiesystem mit einer Objektivlinse mit einem oder mehreren Merkmalen gemäß obiger Beschreibung,

- ein Ionenstrahlbearbeitungssystem zum Manipulieren des Objekts mittels eines emittierten Ionenstrahls,

- eine Objekthalterung zur Halterung und Ausrichtung des Objekts vor dem Ionenstrahlbearbeitungssystem und dem Elektronenmikroskopiesystem, mit der ein flächig ausgedehntes Objekt derart vor dem Elektronenmikroskopiesystem ausrichtbar ist, dass der Ionenstrahl die Objektoberfläche orthogonal schneidet.

Große Vorteile ergeben sich aus einer Kombination des voranstehend beschriebenen Elektronenmikroskopiesystems mit einem Ionenstrahlbearbeitungssystem. Das Ionenstrahlbearbeitungssystem ist zur Erzeugung und Lenkung eines fokussierten Ionenstrahls vorgesehen, mit Hilfe dessen ein zu untersuchendes Objekt beispielsweise durch Abtragen von Material aus einem definierten Bereich der Oberfläche des Objekts manipuliert wird. Neben der Möglichkeit zur Untersuchung von Objekten z. B. in Hinblick auf deren Topographie besteht auch die Möglichkeit, Reparaturarbeiten an lithographischen Masken oder direktschreibende Lithographieverfahren unter Verwendung dieser Anordnung auszuführen. Es sind darüber hinaus weitere Anwendungsmöglichkeiten denkbar. Das Ionenstrahlbearbeitungssystem umfasst zum Erzeugen eines Ionenstrahls eine Ionenquelle, für die häufig eine Flüssigmetall-Ionenquelle (häufig Gallium oder Indium) verwendet wird sowie eine Extraktionselektrode zum Extrahieren von Ionen aus der Ionenquelle durch Anlegen eines elektrostatischen Feldes. Weiterhin umfasst eine Ionenoptik des Ionenstrahlbearbeitungssystems zum Beschleunigen, Fokussieren und Führen bzw. Ablenken des Ionenstrahls zumindest eine Beschleunigungselektrode, elektrostatische Linsen, eine variable Apertur und Ablenkeinheiten.

Das Elektronenmikroskopiesystem und das Ionenstrahlbearbeitungssystem sind derart zueinander angeordnet, dass sich ihre optischen Achsen im Wesentlichen in einer durch eine Oberfläche des zu untersuchenden Objekts definierten Ebene schneiden. Das Objekt wird von einer Objekthalterung gehalten, die eine definierte Ausrichtung des Objekts vor Elektronenmikroskopiesystem und Ionenstrahlbearbeitungssystem erlaubt. So lässt sich der Winkel, unter dem der fokussierte Ionenstrahl und der fokussierte Elektronenstrahl auf der Objektoberfläche auftreffen, in einem definierten Winkelbereich einstellen. Dies erlaubt beispielsweise das Erzeugen von Löchern und Gräben mit unterschiedlich steilen Seitenwänden. Insbesondere lässt sich der Ionenstrahl senkrecht zum Objekt anordnen und ermöglicht daher das Erzeugen von Gräben mit senkrechten Seitenwänden, welchen für bestimmte Anwendungsbereiche eine große Bedeutung zukommen.

Nachfolgend werden Ausführungsbeispiele der Erfindung anhand von Figuren näher erläutert. Hierbei zeigt

Figur 1      eine Querschnittsansicht durch einen unteren Teil einer herkömmlichen Objektivlinse für ein Elektronenmikroskopiesystem,

Figur 2      eine Illustration der in der Beschreibung definierten Winkel und Abmessungen im Bereich eines Polschuhspalts der Objektivlinse,

Figur 3      eine Querschnittsansicht durch ein Ausführungsbeispiel der erfindungsgemäßen Objektivlinse,

Figur 4      einen vergrößerten Ausschnitt aus Figur 3,

Figur 5    einen vergrößerten Ausschnitt aus Figur 3 bzw. 4,

Figur 6    ein Diagramm der für ein Polschuhmaterial eines Ausführungsbeispiels der erfindungsgemäßen Objektivlinse charakteristischen Parameter Feldstärke und Flussdichte,

Figur 7    ein Diagramm der Überlagerung eines elektrostatischen und magnetischen Felds in einem Ausführungsbeispiel der erfindungsgemäßen Objektivlinse, und

Figur 8    eine schematische Darstellung eines erfindungsgemäßen Untersuchungssystems zum Abbilden und Manipulieren eines Objekts.

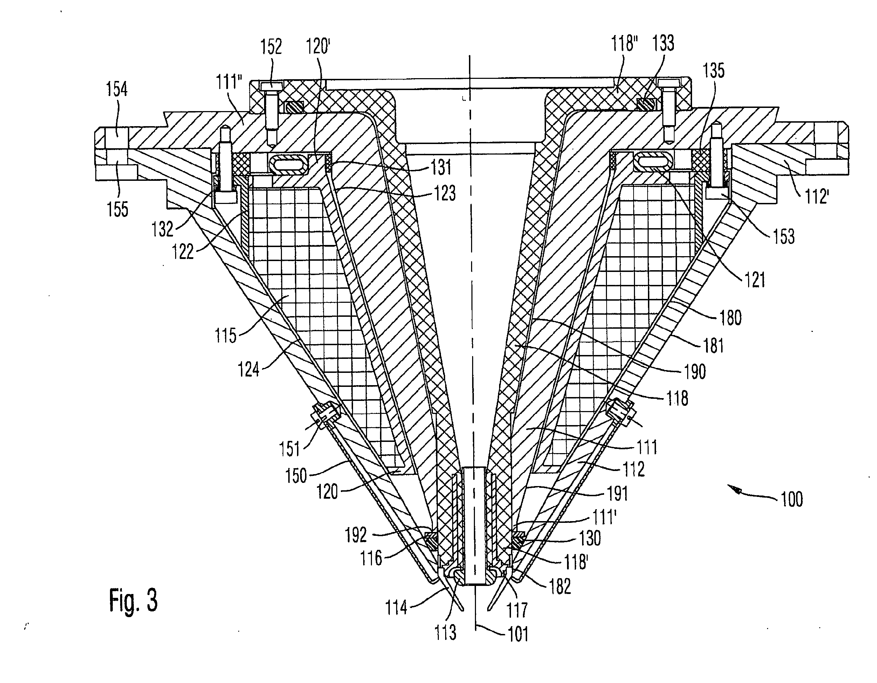

Eine in Figuren 3, 4 und 5 dargestellte Objektivlinse 100 dient zur Fokussierung eines Elektronenstrahls in einer Elektronenmikroskopieanordnung. Die Objektivlinse 100 umfasst eine Magnetlinse sowie eine elektrostatische Linse, folglich erfolgt die Fokussierung sowohl elektrostatisch wie auch magnetisch. Die elektrostatische Linse dient auch zum Abbremsen der Elektronen des Primärelektronenstrahls. Die Magnetlinse umfasst eine Polschuhanordnung mit einem inneren Polschuh 111 und einem äußeren Polschuh 112. Beide Polschuhe 111, 112 sind eine zentrale optische Achse 101, d. h. den Strahlengang eines Primärelektronenstrahls umschließend rotationssymmetrisch ausgebildet.

Der innere Polschuh 111 weist in z-Richtung im Wesentlichen eine konische Form auf und verjüngt sich in diesem konusförmigen Bereich kontinuierlich in Richtung zur Objektebene hin. In einem in z-Richtung untersten Bereich des inneren Polschuhs 111 weist dieser einen sich in z-Richtung über etwa 2,2 mm erstreckenden hohlzylinderförmigen Bereich 111' auf. Die innere Seite 190 des inneren Polschuhs 111 verläuft von einer in z-Richtung untersten Stelle 192 zunächst über etwa 32 mm hinweg parallel zur Achse 101 und erstreckt sich dann entlang einem Konus mit einem Winkel β von 10,5° zur z-Achse, bis dieser in einen Radialflansch 111" übergeht, der in seinem äußeren Bereich einem Radialflanschbereich 112' des äußeren Polschuhs 112 gegenüberliegt. Die äußere, von der Achse 101 weiter entfernte Fläche 191 des inneren Polschuhs 111 verläuft lediglich in dem hohlzylinderförmigen Bereich 111' etwa über 2,2 mm parallel zur optischen Achse und geht dann in einen Konus mit einem Winkel χ von 16° zur z-Achse über, bis dieser in einen Radialflanschteil 111" des inneren Polschuhs 111 übergeht.

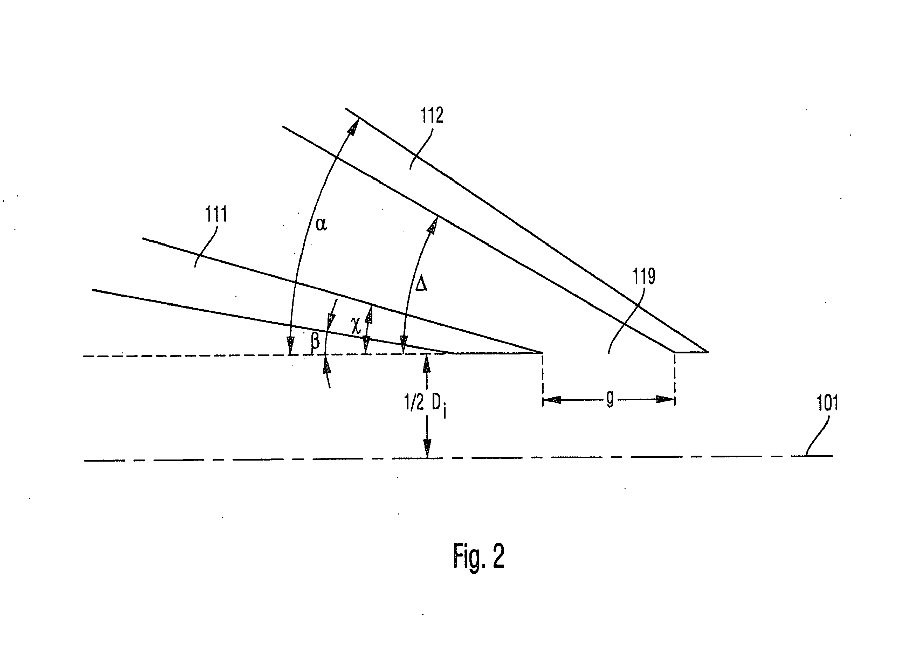

Der äußere Polschuh 112 erstreckt sich bis zu einem oberen Flanschbereich 112' im Wesentlichen konisch in z-Richtung. Dabei bildet eine innere Seite 180 des äußeren Polschuhs 112 in diesem konischen Bereich einen Winkel Δ von 29° zur Achse 101 aus, während eine äußere Seite 181 sich unter einem Winkel α von 34° zur Achse 101 nach radial außen erstreckt. An einer untersten Stelle 182 des äußeren Polschuhs 112 weist dieser eine zentrale Öffnung auf, deren Innendurchmesser im Wesentlichen gleich dem Innendurchmesser $D_i$ (vgl. Figur 2) der Öffnung an der in z-Richtung untersten Stelle 192 im inneren Polschuh 111 entspricht.

Aufgrund der unterschiedlichen Konusöffnungswinkel des inneren und des äußeren Polschuhs (111, 112) nimmt ein Abstand der beiden Polschuhe in Richtung zur Objektebene hin ab und erreicht in einem unteren Bereich 111' des inneren Polschuhs 111 eine kleinste Dimension. Zwischen der untersten Stelle 192 des inneren Polschuhs 111 und der untersten Stelle 182 des äußeren Polschuhs 112 wird ein parallel zur z-Richtung verlaufender, axialer Polschuhspalt 119 mit einem Polschuhabstand ausgebildet. Der Polschuhspalt 119 hat in dieser Ausführungsform eine axiale Länge von etwa 6 mm.

Die Anordnung und Ausgestaltung des Polschuhspalts 119 ist für die Funktion der Magnetlinse von großer Bedeutung. Die Polschuhe 111, 112 "klammern" in gewisser Weise das magnetische Feld. Die Feldlinien verlaufen zwischen dem oberen und dem unteren Polschuh in bauchig in Richtung optischer Achse 101 ausgewölbter Form. Eine maximale Feldstärke auf der optischen Achse 101 wird im Bereich des Polschuhspalts 119 erreicht, wobei die Feldstärke des erzeugten magnetischen Feldes im Wesentlichen in z-Richtung eine Glockenform aufweist.

In der in Figur 3 dargestellten Ausführungsform ist an dem untersten Ende 192 des inneren Polschuhs 111 im Polschuhspalt 119 ein flacher Stützring 116 aus nicht-magnetischem Material angeordnet, der den gleichen Innendurchmesser wie der hohlzylinderförmige Bereich 111' des inneren Polschuhs 111, jedoch einen größeren Außendurchmesser aufweist.

Im Polschuhspalt 119 ist weiterhin ein aus elastischem Material gefertigter Dichtungsring 130 vorgesehen, der an Bereichen des Stützrings 116, des äußeren Polschuh 112 und einem unteren Bereich einer Isolierung 118' anliegt und eine Dichtung des durch die Polschuhe 111, 112 eingeschlossenen Raumes von dem Vakuumraum im Bereich eines zu untersuchenden Objekts und innerhalb des Elektronenmikroskopiesystems bereitstellt.

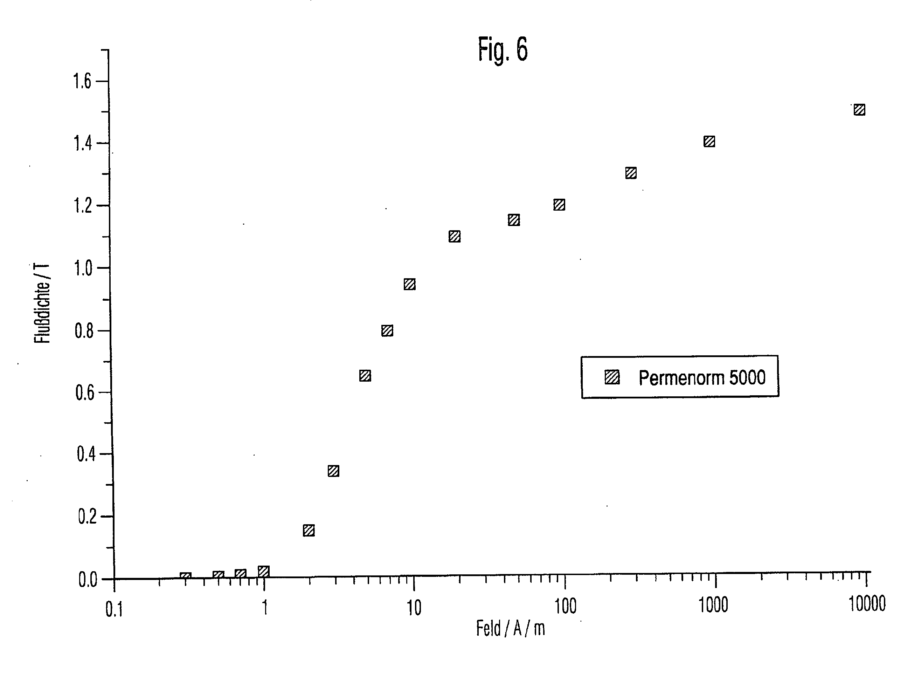

Die Polschuhanordnung ist aus Permenorm® 5000 H3, einer Eisen-Nickel-Legierung, durch Drehen und anschließendes Ausglühen gefertigt. Ein Diagramm der vom Feld abhängigen Flussdichte bzw. Magnetisierung dieses Materials ist in Figur 6 wiedergegeben.

In dem zwischen dem inneren Polschuh 111 und dem äußeren Polschuh 112 gebildeten Innenraum ist ein Spulenkörper 115 angeordnet. Der Spulenkörper 115 umfasst koaxial zur optischen Achse angeordnete Drahtspulen mit einer Drahtdicke von 0,8 mm und ist aus Kupfer gefertigt. Die Zahl der Windungen beträgt 650. Die Spulen können bei einer Stromstärke von maximal 2A betrieben werden. Eine bei Stromdurchfluss durch die Spulen entstehende Wärmeleistung liegt im Bereich von etwa 20 Watt. Zwischen die Spulenwindungen ist ein EpoxyHarz eingefüllt, das nach Aushärten thermische und mechanische Stabilität hervorruft.

Der Spulenkörper 115 ist in seiner Form im Wesentlichen der Form des durch die Polschuhe 111, 112 gebildeten Innenraums angepasst, ohne diesen völlig auszufüllen. So erstrecken sich eine obere Seite und eine innere und eine äußere Seite des Spulenkörpers 115 im Wesentlichen parallel zu den jeweiligen, gegenüberliegenden Flächen der Polschuhanordnung. Zur äußeren Seite 191 des inneren Polschuhs 111, im Wesentlichen zur oberen Seite hin und zu einer unteren Seite hin wird der Spulenkörper 115 durch eine erste Ummantelung 120 spaltfrei eingeschlossen und in einem sich parallel zur z-Achse erstreckenden Bereich der äußeren Seite des Spulenkörpers 115 durch eine zweite Ummantelung 122 spaltfrei umschlossen. Die Ummantelungen 120, 122 sind aus Kupfer gefertigt und dienen der Aufnahme und Ableitung von Wärme, die bei Stromdurchlauf in den Drahtspulen des Spulenkörpers 115 erzeugt wird.

Zwischen der ersten Ummantelung 120 und der äußeren Seite 191 des inneren Polschuhs 111 ist ein sich über die Gesamtheit des der ersten Ummantelung 120 gegenüberliegenden Bereich des inneren Polschuhs 111 ein Spalt 123 belassen, um eine thermische Isolierung bereitzustellen und eine Erwärmung des Polschuhmaterials im Wesentlichen zu verhindern. In einem in z-Richtung obersten Bereich des inneren Polschuhs 111 ist ein ringförmiger Abstandhalter 131 zwischen einem kurzen, vertikalen Fortsatz 120' der ersten Ummantelung 120 und der äußeren Seite 191 des inneren Polschuhs 111 eingesetzt, um eine Berührung von Polschuh 111 und erster Ummantelung 120 zu verhindern und den Spalt 123 bereitzustellen. An den vertikalen Fortsatz der ersten Ummantelung 120 schließt sich in horizontaler Richtung nach radial außen ein von Kühlwasser durchflossenes Rohr 121 an. Zwischen äußerem Polschuh 112 und Spulenkörper 115 ist zur thermischen Isolierung ein Spalt 124 belassen.

Die zweite Ummantelung 122 weist im Wesentlichen eine invertierte L-Form auf und verläuft parallel zu einem zur Achse 101 parallelen Abschnitt der äußeren Seite des Spulenkörpers 115, während sie sich in horizontaler Richtung räumlich an die erste Ummantelung 120 anschließt und eine Bohrung zur Aufnahme einer Schraube 153 aufweist, die zum Verbinden von innerem Polschuh 111 und Spulenkörper 115 mit Ummantelungen 120, 122 unter Verwendung eines Vermittlungskörpers 135 vorgesehen ist. Zwischen einem Kopf der Schraube 153 und der zweiten Ummantelung 122 ist eine Unterlagscheibe 132 angeordnet. Der Flanschbereich 111" des inneren Polschuhs 111 sowie ein diesem gegenüberliegender Flanschbereich 112' des äußeren Polschuhs 112 weisen miteinander fluchtende Bohrungen 154 und 155 zum Verschrauben der beiden Polschuhe 111, 112 miteinander auf. Der äußere Polschuh 112 weist darüber hinaus an seiner äußeren Seite 181 im Bereich des Übergangs von Konusform zum Flanschbereich 112' eine Stufenform auf, die der Einpassung der Polschuhanordnung in ein entsprechendes, zur Aufnahme gefertigtes Teil der Elektronenmikroskopieanordnung dient.

Eine Isolierung 118 aus Kunststoff erstreckt sich parallel zu und entlang der inneren Seite 190 des inneren Polschuhs 111 in einem unteren Bereich über ein unterstes Ende 192 des inneren Polschuhs 111 hinaus bis etwa zu einer untersten Stelle 182 des äußeren Polschuhs 112. In einem oberen Bereich geht die Isolierung 118 parallel zum inneren Polschuh 111 in einen Flanschbereich 118" über, der etwa bis zur Mitte des Flanschbereichs 111" des inneren Polschuhs 111 reicht. In einem Randbereich des Flanschteils 118" der Isolierung 118 ist eine Bohrung zur Aufnahme einer die Isolierung 118 mit dem inneren Polschuh 111 verbindenden Schraube 152 vorgesehen. Ebenfalls in einem Flanschbereich 118" der Isolierung 118 ist in einer dem inneren Polschuh 111 zugewandten Seite der Isolierung 118 eine ringförmige Aussparung zur Aufnahme eines Dichtungsrings 133 vorgesehen. In einem konusförmigen Bereich der inneren Seite des inneren Polschuhs 111 ist die Isolierung 118 vom inneren Polschuh 111 unter Belassung eines Spalts beabstandet. Ebenso wie der innere Polschuh 111 nimmt die Isolierung 118 in einem unteren Bereich eine Hohlzylinderform 118' an. In diesem hohlzylinderförmigen Bereich 118' der Isolierung 118 weist diese eine ringförmige, sich fast über die gesamte Höhe des hohlzylinderförmigen Bereichs erstreckende Aussparung 117 auf, die nicht dargestellte sattelförmige Ablenkspulen zum Ablenken des Elektronenstrahls aufnimmt.

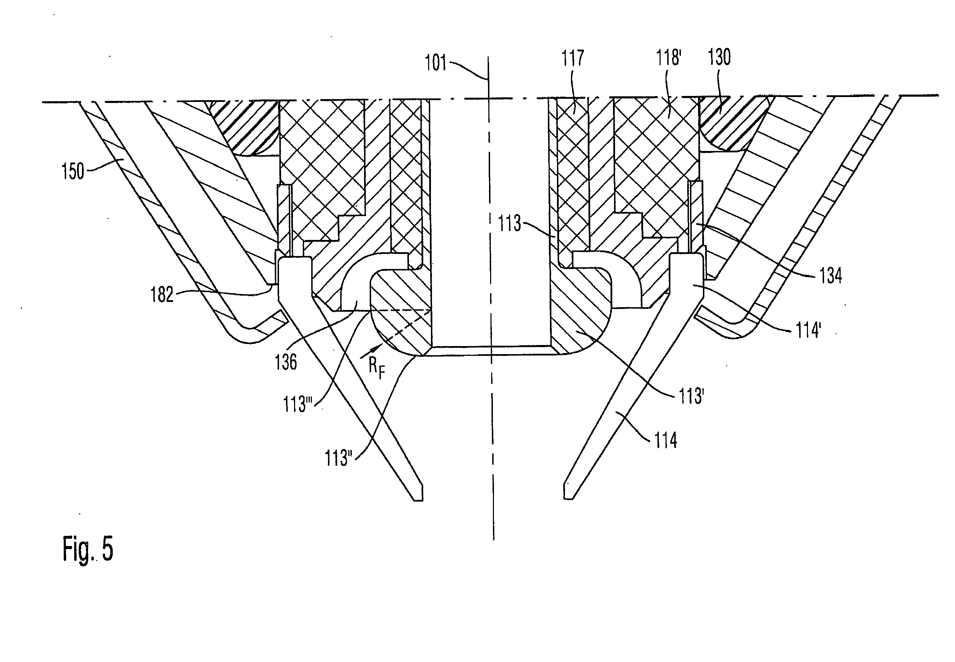

In den Innenradius des hohlzylinderförmigen Bereichs 118' der Isolierung 118 ist das eine erste Elektrode der elektrostatischen Linse ausbildende Strahlrohr 113 eingepasst. Das Strahlrohr 113 erstreckt sich in z-Richtung sowohl über ein oberes wie auch eine unteres Ende des Hohlzylinderbereichs 118' der Isolierung 118 hinaus. Der Innendurchmesser des Strahlrohrs 113 beträgt etwa 4,5 mm. Ein unteres bzw. unterstes Ende des Strahlrohrs 113 weist einen Abstand zur untersten Stelle bzw. dem unteren Ende 182 des äußeren Polschuhs 112 von etwa 5 mm auf. Wie insbesondere aus Figur 5 ersichtlich, weist das Strahlrohr 113 in dieser Ausführungsform einen Endflansch 113' auf, der im axialen Querschnitt eine verrundete Form aufweist und an seiner größten sich radial nach außen erstreckenden Ausdehnung einen Durchmesser von etwa 8,5 mm aufweist. Der Endflansch 113' geht von einem in Richtung der Objektebene weisenden Frontabschnitt 113" in verrundeter Form in einen im Wesentlichen parallel zur Achse 101 angeordneten Mantelabschnitt 113''' über, wobei der Krümmungsradius $R_F$ dieser Verrundung etwa 2 mm beträgt. Der diesem Endflansch 113' zuweisende unterste Teil der Isolierung 118 und die Form des Endflansches 113' des Strahlrohrs 113 sind derart aneinander angepasst, dass ihre Flächen im Wesentlichen parallel angeordnet sind und so ein Spalt 136 von halbrunder Form mit gleichmäßigem Abstand um den Endflansch 113' herum entsteht. Der Endflansch 113' dient dazu, den Kunststoff der Isolierung 118 vor Elektronen und durch diese verursachte Aufladung zu schützen. Im untersten Bereich der Isolierung ist eine Aussparung zur Aufnahme eines Rings 134 vorgesehen, der auf einer von der Isolierung abgewandten Seite zur Anlage an einen Bereich des äußeren Polschuhs kommt.

Des weiteren weist die elektrostatische Linse der Objektivlinse 100 eine Abschlusselektrode 114 als eine zweite Elektrode auf. Diese Abschlusselektrode 114 ist im Wesentlichen von konischer Form, wobei ein Winkel zwischen einer äußeren Seite der Abschlusselektrode 114 und der Achse 101 gleich dem Winkel $\alpha$ zwischen der äußeren Seite 181 des äußeren Polschuhs 112 und der Achse 101 ist, wobei äußerer Polschuh 112 und Abschlusselektrode 114 miteinander fluchten. Die Abschlusselektrode 114 verjüngt sich in z-Richtung bis hin zu einer zentralen Öffnung von etwa 5 mm Innendurchmesser. An einem oberen Ende der Abschlusselektrode 114 geht diese in einen ring- bzw. hohlzylinderförmigen Bereich 114' über, wobei eine Außenfläche dieses Ringbereichs 114' einer axialen Innenfläche des äußeren Polschuhs 112 flächig gegenüberliegt und der zwischen diesen ausgebildete, etwa 150 $\mu$m breite Spalt schmal genug ist, um eine magnetische Kopplung von Abschlusselektrode 114 und äußerem Polschuh 112 zu ermöglichen, wodurch eine noch bessere Abschirmung des Magnetfeldes in der Objektivlinse 100 von einem Bereich außerhalb der Objektivlinse 100 erreicht wird.

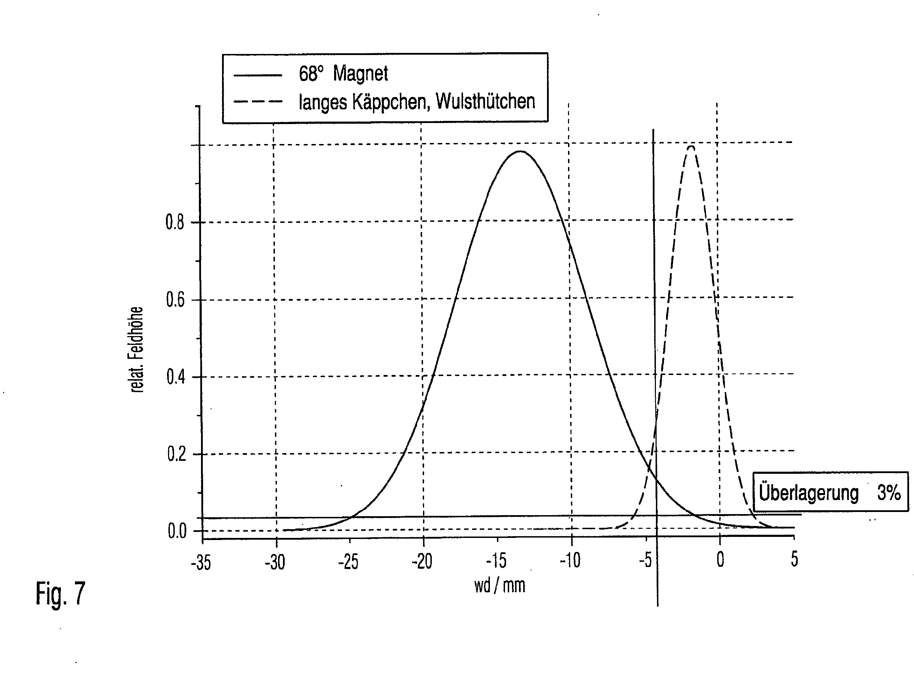

Das untere Ende des Strahlrohrs 113 weist in z-Richtung einen Abstand $A_2$ von etwa 5 mm zu einer untersten Stelle bzw. dem unteren Ende der Abschlusselektrode 114 auf. Während am Strahlrohr 113 eine positive Spannung von 8 kV anliegt, ist die Abschlusselektrode 114 vorzugsweise auf Erdpotential geschaltet. Durch die Wahl dieser gegenüber dem Stand der Technik größeren Abstände der Elektroden 113, 114 der elektrostatischen Linse voneinander und von der Polschuhanordnung wird das elektrostatische Verzögerungs- und Fokussierungsfeld von dem durch die Polschuhanordnung erzeugten Magnetfeld weitgehend separiert, die Felder der beiden Linsen überlappen in einem Bereich von weniger als 5 % ihrer Feldintegrale, wie aus dem Diagramm in Figur 7 ersichtlich. (Die Abschlusselektrode mit Endflansch ist in der Legende von Figur 7 als "langes Käppchen, Wulsthütchen" bezeichnet.)

Die Abschlusselektrode 114 ist aus Mumetall®, nämlich einem von der Vakuumschmelze Hanau, Deutschland, unter dem Namen Hyperm 766 erhältlichen Material gefertigt.

Die Abschlusselektrode 114 wird durch zwei gegenüberliegende, in einem oberen Bereich mit Schrauben 151 am äußeren Polschuh 112 befestigte Klammern 150 gehalten. Die Klammern 150 sind in ihrem unteren Bereich an einem obersten konusförmigen Abschnitt der Abschlusselektrode 114 angeordnet. Die Abschlusselektrode 114 wird durch die Isolierung 118' gehalten und zentriert. Zur elektrischen Isolation der Klammern 150 vom äußeren Polschuh 112 wird keramisches Isolierungsmaterial unter der äußeren Polschuh 112 und Klammer 150 verbindenden Schraube 151 verwendet. Diese Anordnung bzw. Halterung ermöglicht ein leichtes Auswechseln der Abschlusselektrode 114. Zudem kann die Abschlusselektrode 114 elektrisch isoliert von dem äußeren Polschuh 112 auf ein anderes Potential als Erdpotential geschaltet werden.

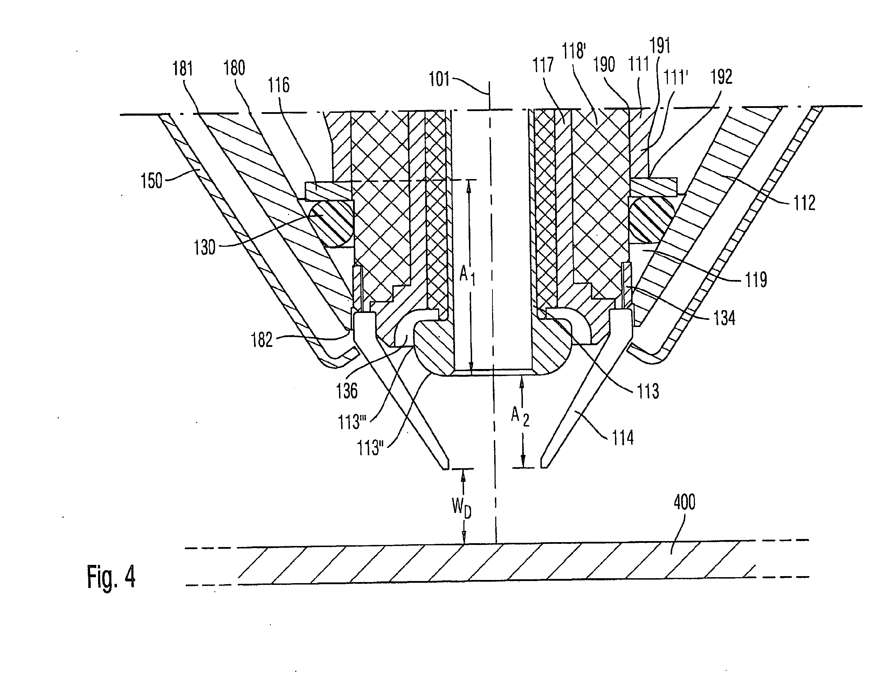

In Figur 4 ist zusätzlich ein zu untersuchendes Objekt 400 sowie ein Arbeitsabstand $W_D$ zwischen dem unteren Ende der Abschlusselektrode 114 und einer Oberfläche des Objekts 400 sowie die Abstände $A_1$ und $A_2$ dargestellt.

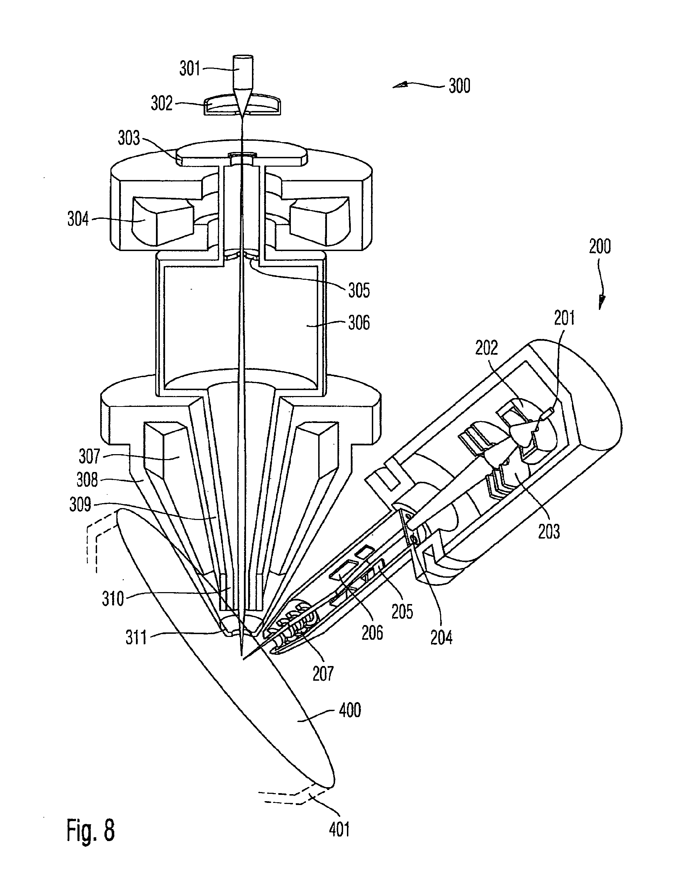

In Figur 8 ist in schematischer, vereinfachter Form ein Ausführungsbeispiel des Untersuchungssystem zum Abbilden und Manipulieren eines Objekts 400 dargestellt. Das Untersuchungssystem umfasst Elektronenmikroskopiesystem 300 zum Abbilden eines Bereichs des Objekts 400 sowie Ionenstrahlbearbeitungssystem 200 zum Manipulieren des Objekts 400.

Wie aus Figur 8 ersichtlich, schneiden sich die optischen Achsen von Elektronenmikroskopiesystem 300 und Ionenstrahlbearbeitungssystem 200 im Wesentlichen in einer durch die plane Oberfläche des Objekts 400 definierten Ebene, wobei die optische Achse des Ionenstrahlbearbeitungssystems 200 in etwa orthogonal zu dieser Ebene angeordnet ist und der Ionenstrahl entsprechend senkrecht auf eine Oberfläche des Objekts 400 auftrifft. Der Einfallswinkel des Elektronenstrahls auf das Objekt 400 beträgt in der Figur dargestellten Anordnung in etwa 35°, während der Arbeitsabstand, d. h. der Abstand zwischen der Oberfläche des Objekts 400 und der untersten, radial innersten Stelle in der zentralen Öffnung der Abschlusselektrode etwa 4 mm beträgt.

Im Elektronenmikroskopiesystem 300 wird ein Primärelektronenstrahl durch eine Elektronenstrahlquelle erzeugt, welche eine Kathode 301, vorzugsweise einen Schottky-Feldemitter, und eine der Kathode 301, gegenüberliegende Anode 303 umfasst. Die emittierten Elektronen durchlaufen zudem einen zwischen Kathode 301 und Anode 303 angeordneten Extraktor 302. Der beschleunigte Primärelektronenstrahl tritt durch eine Bohrung am Boden der Anode 303 hindurch und wird anschließend von einer Kollimatoranordnung 304 kollimiert. Der Elektronenstrahl durchläuft nach einer Aperturblende 305 einen Innenraum 306 des Elektronenmikroskopiesystems 300, in dem ein nicht dargestellter Detektor zum Nachweis von Sekundärelektronen oder Rückstreuelektronen angeordnet ist. Mittels der aus der Polschuhanordnung mit innerem Polschuh 309 und äußerem Polschuh 308 sowie dem zwischen diesen angeordneten Spulenkörper 307 ausgebildeten Magnetlinse und der elektrostatischen Linse 310, 311, welche zusammen die Objektivlinse ausbilden, wird der Elektronenstrahl fokussiert. In der Objektivlinse sind zudem symmetrisch um den Strahlengang herum Sattelspulen zum Ablenken des Elektronenstrahls angeordnet. Aus der Objektivlinse tritt der Elektronenstrahl aus und trifft unter einem Winkel von etwa 35° bei einem Arbeitsabstand von etwa 4 mm auf die Objektoberfläche. Die Objektivlinse wurde im vorangehenden Ausführungsbeispiel bereits detailliert beschrieben.

Ionenstrahlbearbeitungssystem 200 weist eine Ionenquelle 201 auf, die eine Anordnung mit einem an einer Spitze angeordneten Tropfen flüssigen Galliums umfasst, aus welchem mit Hilfe einer Extraktionselektrode 202 ein lonenstrahl extrahiert wird. Dieser durchläuft, vereinfacht dargestellt, beim Durchgang durch die Ionenoptik der FIB-Säule 200 nacheinander einen Kollimator 203, eine variable Blende 204, einen Satz von Elektroden 205 und 206 zur Ablenkung und Ausrichtung des lonenstrahls und schließlich eine Anordnung von strahlformenden Einzellinsen 207, bevor der lonenstrahl aus der FIB-Säule austritt.

Der fokussierte lonenstrahl trifft in Figur 8 etwa rechtwinklig zur Objektoberfläche auf das Objekt, so dass Gräben oder Löcher mit senkrechten Wänden in der Objektoberfläche bei simultaner Beobachtung durch die Elektronenmikroskopieanordnung erzeugt werden können.

Weiterhin ist in Figur 8 eine Objekthalterung 401 zum Haltern und Ausrichten des Objekts 400 vor Elektronenmikroskopiesystem 300 und lonenstrahlbearbeitungssystem 200 angedeutet.

Ein großer Vorteil des erfindungsgemäßen Systems ist es, ein Objekt gleichzeitig beobachten und bearbeiten zu können. Abbilden der Objektbearbeitung in situ ist insbesondere zur Endpunktbestimmung bei der Erzeugung besonders komplexer und/oder kleiner Strukturen von Bedeutung. Simultanes Bearbeiten und Abbilden wird unter anderem dadurch ermöglicht, dass das magnetische Feld der Magnetlinse der Objektivlinse des Elektronenstrahlmikroskopiesystems derart durch die Objektivlinse abgeschirmt wird, dass im Bereich der Objektoberfläche bzw. des vom lonenstrahl durchsetzten Raums ein Magnetfeld so gering ist, dass kein oder ein vernachlässigbar kleiner störender Einfluss auf den lonenstrahl ausgeübt wird. Dies ist insbesondere gegenüber sogenannten "single pole"-Objektivlinsen von großem Vorteil, deren Raumbedarf zwar recht klein gestaltet werden kann, die jedoch naturgemäß ein großes Magnetfeld im Bereich des Objekts erzeugen und so nicht gleichzeitig mit einem fokussierten lonenstrahl eingesetzt werden können.

Ausgehend von einem Winkel von 34° oder weniger zwischen der Außenseite des äußeren Polschuhs der Objektivlinse der Elektronenmikroskopieanordnung und einem Winkel von 20° zwischen einer zumindest in einem dem Objekt zuweisenden unteren Bereich konusförmig gestalteten Außenseite der FIB-Säule und deren optischer Achse (halber Öffnungswinkel) lassen sich FIB-Säule und Elektronenmikroskopieanordnung in einer Ebene senkrecht zur Objektebene derart anordnen, dass in dieser 180° überspannenden Ebene der fokussierte lonenstrahl unter einem Winkel von etwa 21° bis (180° - 2x34° - 20° =) 92° auf das Objekt treffen kann, wobei der Elektronenstrahl gleichzeitig unter einem Winkel von etwa (0° + 2×20° + 34° =) 74° bis (180° - 34° =) 146° auf das Objekt treffen kann, wobei der Winkel zwischen Elektronenstrahl und lonenstrahl immer mindestens (20° + 34° =) 54° beträgt. Damit läßt sich der fokussierte lonenstrahl auch beispielsweise um 2° in jede Richtung abweichend von der Orthogonalen auf die Objektebene richten, was zum Beispiel für das Erzeugen von Proben für die Transmissionselektronenmikroskopie von Bedeutung ist.

Die vorliegende Beschreibung offenbart die nachfolgend zusammenfassend aufgeführte Liste von Merkmalskombinationen. Diese Liste von Merkmalskombinationen fasst die Offenbarung der vorliegenden Anmeldung zusammen, und der Durchschnittsfachmann wird erkennen, dass diese Liste von Merkmalskombinationen nicht den Schutzbereich der vorliegenden Erfindung wiedergibt, da der Schutzbereich der vorliegenden Erfindung durch die Patentansprüche definiert ist, welche dieser Beschreibung als ein mit dem Titel "Patentansprüche" überschriebener Abschnitt beigefügt sind.

Kombination 1.: Objektivlinse für ein Elektronenmikroskopiesystem mit magnetischer und elektrostatischer Fokussierung zur Erzeugung einer Abbildung eines in einer Objektebene anordenbaren Objekts, umfassend: eine bezüglich einer sich in einer z-Richtung erstreckenden optischen Achse der Objektivlinse im Wesentlichen rotationssymmetrische Polschuhanordnung zur Erzeugung eines fokussierenden Magnetfeldes mit einem inneren Polschuh und einem äußeren Polschuh, wobei ein Polschuhspalt zwischen dem inneren und dem äußeren Polschuh gebildet ist an einer in z-Richtung untersten Stelle des inneren Polschuhs, wo dieser von dem äußeren Polschuh einen in z-Richtung orientierten Spaltabstand aufweist; einen in einem Raum zwischen dem inneren und dem äußeren Polschuh angeordneten Spulenkörper; eine bezüglich der optischen Achse im Wesentlichen rotationssymmetrische Elektrodenanordnung zur Erzeugung eines fokussierenden elektrostatischen Feldes mit einem den inneren Polschuh entlang der optischen Achse durchsetzenden Strahlrohr mit einem unteren Ende und einer mit Abstand von dem unteren Ende des Strahlrohrs angeordneten Abschlusselektrode, dadurch gekennzeichnet, dass in einem Bereich innerhalb von wenigstens 3 cm um den Polschuhspalt gilt: wenigstens bereichsweise verjüngt sich der innere Polschuh nach unten und weist dort einen inneren Konuswinkel $\beta$ und einen äußeren Konuswinkel $\chi$ zur z-Richtung auf, der äußere Polschuh erstreckt sich wenigstens bereichsweise konisch nach unten und weist dort einen inneren Konuswinkel $\Delta$ und einen äußeren Konuswinkel $\alpha$ zur z-Richtung auf, und wobei die Objektivlinse dazu ausgebildet ist, dass ein Arbeitsabstand zwischen der Abschlusselektrode und der Objektebene kleiner als 2 mm für Elektronen ist, die das Strahlrohr mit etwa 30 keV durchlaufen, und wobei gilt:

$$30° < \alpha < 35° \text{ und } 10° < \Delta\text{-}\chi < 14°.$$

Kombination 2.: Objektivlinse nach Kombination 1 oder dem Oberbegriff von Kombination 1, wobei der äußere Polschuh außen im Wesentlichen durch eine Konusfläche mit einem Konuswinkel $\alpha$ zur z-Richtung begrenzt ist, wobei die Abschlusselektrode außen im Wesentlichen durch eine Konusfläche mit einem Konuswinkel $\alpha'$ zur z-Richtung begrenzt ist, wobei die Abschlusselektrode zum Reduzieren des Magnetfelds in der Objektebene im Wesentlichen spaltfrei magnetisch an den äußeren Polschuh gekoppelt ist.

Kombination 3.: Objektivlinse nach Kombination 2, wobei die Objektivlinse dazu ausgebildet ist, dass ein Arbeitsabstand kleiner als 2 mm ist für Elektronen, die das Strahlrohr mit etwa 30 keV durchlaufen.

Kombination 4.: Objektivlinse nach Kombination 2 oder 3, wobei ein Spalt zwischen der Abschlusselektrode und dem äußeren Polschuh kleiner als 0,6 mm, vorzugsweise kleiner als 0,2 mm ist.

Kombination 5.: Objektivlinse nach einer der Kombinationen 2 bis 4, wobei ein Bereich der Abschlusselektrode einem Bereich des äußeren Polschuhs flächig gegenüberliegt.

Kombination 6.: Objektivlinse nach einer der Kombination 1 bis 5 oder dem Oberbegriff von Anspruch 1, wobei ein Abstand zwischen der in z-Richtung untersten Stelle des inneren Polschuhs und dem unteren Ende des Strahlrohrs größer ist als 9 mm, insbesondere größer als 10 mm ist.

Kombination 7.: Objektivlinse nach einem der vorangehenden Ansprüche, wobei das elektrostatische Feld und das Magnetfeld um weniger als 5 % überlappen.

Kombination 8.: Objektivlinse nach einer der vorangehenden Kombinationen, wobei das Strahlrohr eine durch einen in z-Richtung untersten Bereich des äußeren Polschuhs gebildete Öffnung des äußeren Polschuhs durchsetzt und das untere Ende des Strahlrohrs in z-Richtung von der Öffnung des äußeren Polschuhs mit Abstand angeordnet ist.

Kombination 9.: Objektivlinse nach Kombination 8, wobei das untere Ende des Strahlrohrs einen sich radial über einen Außendurchmesser des Strahlrohrs hinaus erstreckenden Endflansch aufweist.

Kombination 10.: Objektivlinse nach Kombination 9, wobei der Endflansch im Axialquerschnitt einen verrundeten Übergang von einem Frontabschnitt in einen Mantelabschnitt aufweist, wobei ein Krümmungsradius der Verrundung größer als 1 mm ist.

Kombination 11.: Objektivlinse nach einer der Kombinationen 8 bis 10, wobei ein Abstand zwischen dem unteren Ende des Strahlrohrs und dem unteren Ende der Abschlusselektrode größer als 3 mm ist.

Kombination 12.: Objektivlinse nach einer der vorangehenden Kombinationen, wobei die Abschlusselektrode im Wesentlichen bis zu einer zentralen Öffnung in der Abschlusselektrode hin sich konisch verjüngt.

Kombination 13.: Objektivlinse nach Kombination 12, wobei ein Innendurchmesser der Öffnung der Abschlusselektrode im Wesentlichen einem Innendurchmesser des Strahlrohrs entspricht.

Kombination 14.: Objektivlinse nach einer der vorangehenden Kombinationen, wobei der äußere Polschuh sich nach unten verjüngt.

Kombination 15.: Objektivlinse nach einer der vorangehenden Kombinationen, wobei der Spaltabstand größer als 3 mm ist.

Kombination 16.: Objektivlinse nach einer der vorangehenden Kombinationen, wobei der innere Polschuh sich von seinem unteren Ende aus als ein Zylindermantel etwa 1 mm bis 2 mm nach oben erstreckt und dann sich konisch erweitert.

Kombination 17.: Objektivlinse nach einer der vorangehenden Kombinationen, wobei der innere Polschuh an seinem unteren Ende einen Innendurchmesser von 6 mm bis 8 mm aufweist.

Kombination 18.: Untersuchungssystem zur Beobachtung und zur Manipulation eines zu untersuchenden Objekts, umfassend: ein Elektronenmikroskopiesystem mit einer Objektivlinse gemäß einer der Kombinationen 1 bis 17, und ein lonenstrahlbearbeitungssystem zum Manipulieren des Objekts mittels eines emittierten lonenstrahls, eine Objekthalterung zur Halterung und Ausrichtung des Objekts vor dem lonenstrahlbearbeitungssystem und dem Elektronenmikroskopiesystem, mit der ein flächig ausgedehntes Objekt derart vor dem Elektronenmikroskopiesystem und dem lonenstrahlbearbeitungssystem ausrichtbar ist, dass der lonenstrahl die Objektoberfläche orthogonal schneidet.

Kombination 19.: Untersuchungssystem nach Kombination 18, wobei das Objekt derart vor dem Elektronenmikroskopiesystem und dem lonenstrahlbearbeitungssystem ausrichtbar ist, dass der Ionenstrahl die Objektoberfläche um einen Winkel von bis zu 2° von der Orthogonalen auf die Objektoberfläche abweichend schneidet.

**Patentansprüche**

1. Objektivlinse (100) für ein Elektronenmikroskopiesystem mit magnetischer und elektrostatischer Fokussierung zur Erzeugung einer Abbildung eines in einer Objektebene anordenbaren Objekts, umfassend:

   eine bezüglich einer sich in einer z-Richtung erstreckenden optischen Achse (101) der Objektivlinse (100) im Wesentlichen rotationssymmetrische Polschuhanordnung zur Erzeugung eines fokussierenden Magnetfeldes mit einem inneren Polschuh (111) und einem äußeren Polschuh (112), wobei ein Polschuhspalt (119) zwischen dem inneren und dem äußeren Polschuh (111, 112) gebildet ist an einer in z-Richtung untersten Stelle des inneren Polschuhs (192), wo dieser von dem äußeren Polschuh (112) einen in z-Richtung orientierten Spaltabstand aufweist;
   einen in einem Raum zwischen dem inneren und dem äußeren Polschuh (111, 112) angeordneten Spulenkörper (115);
   eine bezüglich der optischen Achse (101) im Wesentlichen rotationssymmetrische Elektrodenanordnung zur Erzeugung eines fokussierenden elektrostatischen Feldes mit einem den inneren Polschuh (111) entlang der optischen Achse (101) durchsetzenden Strahlrohr (113) mit einem unteren Ende und einer mit Abstand von dem unteren Ende des Strahlrohrs (113) angeordneten Abschlusselektrode (114),

   **dadurch gekennzeichnet, dass** der äußere Polschuh (112) außen im Wesentlichen durch eine Konusfläche mit einem Konuswinkel $\alpha$ zur z-Richtung begrenzt ist, wobei die Abschlusselektrode (114) außen im Wesentlichen durch eine Konusfläche mit einem Konuswinkel $\alpha'$ zur z-Richtung begrenzt ist, wobei die Abschlusselektrode (114) zum Reduzieren des Magnetfelds in der Objektebene im Wesentlichen spaltfrei magnetisch an den äußeren Polschuh (112) gekoppelt ist.

2. Objektivlinse (100) nach Anspruch 1, wobei die Objektivlinse dazu ausgebildet ist, dass ein Arbeitsabstand kleiner als 2 mm ist für Elektronen, die das Strahlrohr mit etwa 30 keV durchlaufen.

3. Objektivlinse (100) nach Anspruch 2, wobei ein Spalt zwischen der Abschlusselektrode (114) und dem äußeren Polschuh (112) kleiner als 0,6 mm, vorzugsweise kleiner als 0,2 mm ist.

4. Objektivlinse (100) nach einem der Ansprüche 1 bis 3, wobei ein Bereich der Abschlusselektrode (114) einem Bereich des äußeren Polschuhs (112) flächig gegenüberliegt.

5. Objektivlinse (100) nach einem der Ansprüche 1 bis 4 oder dem Oberbegriff von Anspruch 1, wobei ein Abstand ($A_1$) zwischen der in z-Richtung untersten Stelle (192) des inneren Polschuhs (111) und dem unteren Ende des Strahlrohrs (113) größer ist als 9 mm, insbesondere größer als 10 mm ist.

6. Objektivlinse (100) nach einem der vorangehenden Ansprüche, wobei das Strahlrohr (113) eine durch einen in z-Richtung untersten Bereich (182) des äußeren Polschuhs (112) gebildete Öffnung des äußeren Polschuhs (112) durchsetzt und das untere Ende des Strahlrohrs (113) in z-Richtung von der Öffnung des äußeren Polschuhs (112) mit Abstand angeordnet ist.

7. Objektivlinse (100) nach Anspruch 6, wobei das untere Ende des Strahlrohrs (113) einen sich radial über einen Außendurchmesser des Strahlrohrs hinaus erstreckenden Endflansch (113') aufweist.

8. Objektivlinse (100) nach einem der Ansprüche 6 oder 7, wobei ein Abstand ($A_2$) zwischen dem unteren Ende des Strahlrohrs (113) und dem unteren Ende der Abschlusselektrode (114) größer als 3 mm ist.

9. Objektivlinse (100) nach einem der vorangehenden Ansprüche, wobei die Abschlusselektrode (114) sich im Wesentlichen bis hin zu einer zentralen Öffnung in der Abschlusselektrode (114) konisch verjüngt.

10. Objektivlinse (100) nach Anspruch 9, wobei ein Innendurchmesser der Öffnung der Abschlusselektrode (114) im Wesentlichen einem Innendurchmesser des Strahlrohrs (113) entspricht.

11. Objektivlinse (100) nach einem der vorangehenden Ansprüche, wobei der äußere Polschuh sich nach unten verjüngt.

12. Objektivlinse (100) nach einem der vorangehenden Ansprüche, wobei der innere Polschuh (111) sich von seinem unteren Ende (192) aus als ein Zylindermantel (111') etwa 1 mm bis 2 mm nach oben erstreckt und dann sich konisch erweitert.

13. Objektivlinse (100) nach einem der vorangehenden Ansprüche, wobei der innere Polschuh (111) an seinem unteren Ende (192) einen Innendurchmesser von 6 mm bis 8 mm aufweist.

14. Untersuchungssystem zur Beobachtung und zur Manipulation eines zu untersuchenden Objekts (400), umfassend:

   ein Elektronenmikroskopiesystem (300) mit einer Objektivlinse nach einem der Ansprüche 1 bis 13, und
   ein Ionenstrahlbearbeitungssystem (200) zum Manipulieren des Objekts (400) mittels eines emittierten Ionenstrahls,
   eine Objekthalterung (401) zur Halterung und Ausrichtung des Objekts (400) vor dem Ionenstrahlbearbeitungssystem (200) und dem Elektronenmikroskopiesystem (300), mit der ein flächig ausgedehntes Objekt (400) derart vor dem Elektronenmikroskopiesystem (300) und dem Ionenstrahlbearbeitungssystem (200) ausrichtbar ist, dass der Ionenstrahl die Objektoberfläche orthogonal schneidet.

15. Untersuchungssystem nach Anspruch 14, wobei das Objekt (400) derart vor dem Elektronenmikroskopiesystem (300) und dem Ionenstrahlbearbeitungssystem (200) ausrichtbar ist, dass der Ionenstrahl die Objektoberfläche um einen Winkel von bis zu 2° von der Orthogonalen auf die Objektoberfläche abweichend schneidet.

Fig. 1

(Stand der Technik)

50°

11

15

1

12

19

2

13

14

EP 2 418 673 A2

Fig. 2

Fig. 3

EP 2 418 673 A2

Fig. 4

Fig. 5

Fig. 6

EP 2 418 673 A2

Fig. 7

Fig. 8